# EUROPÄISCHE PATENTSCHRIFT

(11) **EP 1 912 285 B1**
(45) Veröffentlichungstag und Bekanntmachung des Hinweises auf die Patenterteilung: **14.12.2011**
(21) Anmeldenummer: 07019704.1
(22) Anmeldetag: 09.10.2007
(51) Int. Cl.: H01R 9/24

(54) **Elektrisches oder elektronisches Gerät**
Electric or electronic device
Appareil électrique ou électronique

(30) Priorität: 13.10.2006 DE 202006015897 U
(43) Veröffentlichungstag der Anmeldung: 16.04.2008
(73) Patentinhaber: PHOENIX CONTACT GmbH & Co. KG, 32825 Blomberg (DE)
(72) Erfinder: Schulze, Volker, Dipl.-Ing., 32825 Blomberg (DE); Eusterholz, Hemut, Dipl.-Ing., 33102 Paderborn (DE)
(74) Vertreter: Gesthuysen, von Rohr & Eggert

(56) Entgegenhaltungen:
- DE-U1- 29 603 161
- DE-U1- 29 606 759
- DE-U1- 29 713 960
- US-B1- 6 811 425

## Beschreibung

Die Erfindung betrifft ein elektrisches oder elektronisches Gerät, insbesondere zum Aufsetzen auf eine Tragschiene, mit einem Gehäuse, mit einer im Gehäuse angeordneten Elektronik, insbesondere einer Leiterplatte, und mit mindestens einem Steckverbinder, wobei in dem Gehäuse mindestens ein Steckanschluß zur Aufnahme eines Steckverbinders ausgebildet ist und der Steckanschluß mindestens ein Kontaktelement aufweist, das mit der Elektronik verbunden ist, so daß mit Hilfe des Steckverbinders mindestens eine elektrische Leitung an die Elektronik anschließbar ist, und wobei am Gehäuse im Bereich oberhalb mindestens eines Steckanschlusses ein Verriegelungselement zur Verriegelung eines eingesteckten Steckverbinders schwenkbar angeordnet ist. Daneben betriff die Erfindung auch ein Gehäuse für ein derartiges elektrisches oder elektronisches Gerät.

Modulare Elektronikkomponenten benötigen eine funktionsgerechte Verpackung, die unterschiedliche Einstell- und Bedienfunktionen zulassen und möglichst einfach aber dennoch sicher und zuverlässig montierbar sein muß. Mit dem Trend zur zunehmenden Steuerung und Automatisierung von Abläufen insbesondere im industriellen Bereich, bei gleichzeitiger Dezentralisierung von Elektronik direkt in den Prozeß sowie der Miniaturisierung von Elektronikbaugruppen zu kompakten, montagefreundlichen Geräten werden daher zunehmend geeignete Elektronikgehäuse benötigt, wobei in der Regel dann auch die Anschlußtechnik in dem Gehäuse integriert ist. Die einzelnen elektronischen Geräte werden dabei in der Regel direkte auf einer Tragschiene montiert und bevorzugt über ein Bus-System miteinander und mit einer Steuerung verbunden.

Hierbei gibt es je nach Anwendungsfall eine Vielzahl von unterschiedlichen elektronischen Geräten und Gehäuseformen, die sich in ihrer Größe, ihrem Aufbau und ihrer Funktion unterscheiden. Gemeinsam ist all diesen elektronischen Geräten, daß in ihrem Inneren elektronische Baugruppen, meist in Form von Leiterplatten, angeordnet sind, welche durch das Elektronikgehäuse vor Berührung und Schmutz geschützt werden. Derartige Gehäuse sind meist modular aufgebaut, so daß ein Einsetzen oder Austauschen einer Leiterplatte und damit das Anpassen des elektronischen Geräts an unterschiedliche Bedingungen schnell und einfach möglich ist.

Häufig bestehen die Gehäuse aus einem Gehäuseoberteil und einem Gehäuseunterteil, wobei das Gehäuseoberteil Anschlüsse für elektrische Leitungen aufweist, die Anschlüsse über Steckerkontakte mit dem Gehäuseunterteil verbunden sind und das Gehäuseunterteil die Verbindung zu einem Bus-System herstellt. Die einzelnen Gehäuse sind dabei so ausgebildet, daß mehrere Gehäuse benachbart zueinander auf einer Tragschiene aufrastbar sind, so daß mehrere Gehäuse zusammen einen Gehäuseblock bilden. Dabei sind die einzelnen benachbarten Gehäuse bzw. die einzelnen benachbarten elektronischen Geräte vorzugsweise elektrisch miteinander kontaktierbar.

Die Befestigung derartiger Gehäuse bzw. elektronischer Geräte auf der Tragschien erfolgt nun dadurch, daß in der Gehäuseunterseite ein Verriegelungselement angeordnet ist, wobei das Verriegelungselement dann, wenn das Gehäuse auf der Tragschiene aufgesetzt ist, mit der Tragschiene verrastet. Um das Gehäuse - und damit auch das elektronische Gerät - von der Tragschiene zu lösen, muß die zuvor beschriebene Verrastung gelöst werden, wozu das in der Regel federbeaufschlagte Verriegelungselement gegen seine Federkraft zurückgezogen werden muß.

Ein derartiges elektronisches Gerät ist aus dem Katalog "Leiterplattenanschluß COMBICON 2005" der Phoenix Contact, Seiten 378 bis 387 sowie aus der DE 297 13 960 U1, insbesondere Figur 10, bekannt. Bei dem bekannten Gerät ist es so, daß dieses auf eine handelsübliche Tragschiene aufrastbar ist und beim Aufrasten automatisch mit benachbarten Geräten durchkontaktiert wird. Auf diese Weise ergibt sich über die durchkontaktierten Geräte eine Busverbindung.

Der Anschluß von elektrischen Leitungen an das elektronische Gerät erfolgt einfach mittels Steckverbindern, die in an den Stirnseiten des Gehäuses angeordneten Steckanschlüssen eingesteckt werden können. Dabei können die Steckverbinder insbesondere Schraubanschlüsse, Federkraftanschlüsse oder Schneidanschlüsse, sogenannte Insulation-Displacement-Connection (IDC) Anschlüsse zum Anschließen der elektrischen Leitungen aufweisen. Je nach Baubreite des elektronischen Geräts weisen die einzelnen Steckverbinder unterschiedliche Polzahlen auf, so daß an die einzelnen elektronischen Geräte eine entsprechende Anzahl von elektrischen Leitungen angeschlossen werden kann; typische elektronische Geräte weisen 8, 12, 16, 24, 32 oder auch 48 Pole auf, wobei dann in der Regel an beiden Stirnseiten des elektronischen Geräts mindestens zwei Steckverbinder übereinander angeordnet sind.

Der Vorteil der Steckverbinder gegenüber einer festen Verdrahtung, beispielsweise mittels Schraubanschlüsse oder Federkraftanschlüsse, am elektronischen Gerät besteht darin, zunächst die elektrischen Leitungen an die Steckverbinder angeschlossen und anschließen die fertig verdrahteten Steckverbinder in die Steckanschlüsse eingesteckt werden können. Außerdem müssen bei einem Austausch eines defekten Geräts nur die Steckverbinder aus den Steckanschlüssen herausgezogen werden, ohne daß die einzelnen elektrischen Leitungen gelöst werden müssen. Diese Flexibilität führt jedoch auch dazu, daß es bei Erschütterungen zu einem ungewollten Lösen bzw. Teillösen der Steckverbinder aus den Steckanschlüssen kommen kann. Außerdem besteht die Gefahr, daß ein Steckverbinder bei der Montage nicht vollständig in einen Steckanschluß eingesteckt wird, so daß es zu Wackelkontakten kommen kann.

Aus der US 6,811,425 B1 ist ein eingangs beschriebenes elektronisches Gerät bekannt, bei dem am Gehäuse im Bereich oberhalb der beiden Steckanschlüsse jeweils eine Abdeckung zur Verriegelung eines eingesteckten Steckverbinders schwenkbar angeordnet ist. Damit bei diesem Gerät auch bei geschlossener Abdeckung ein Prüfstecker in eine Öffnung in Steckverbinder eingesteckt werden kann, sind in der Abdeckung korrespondierend zu den Öffnungen im Prüfsteckers entsprechende Öffnungen ausgebildet, durch die der Prüfstecker durchgesteckt werden kann.

Der vorliegenden Erfindung liegt die Aufgabe zugrunde, ein eingangs beschriebenes elektrisches oder elektronisches Gerät bzw. ein Gehäuse für ein derartiges Gerät derart weiterzubilden, daß es in der Praxis noch zuverlässiger eingesetzt werden kann, wobei die Handhabung möglichst nicht oder nur geringfügig beeinträchtigt werden soll.

Diese Aufgabe ist bei dem eingangs beschriebenen elektrischen oder elektronischen Gerät dadurch gelöst, daß das Verriegelungselement näherungsweise U-förmig ausgebildet ist, mit einem einen eingesteckten Steckverbinder abdeckenden U-Rücken einem die Vorderkante eines eingesteckten Steckverbinders übergreifenden, als Rastelement ausgebildeten ersten U-Schenkel und einem eine hintere Kante eines eingesteckten Steckverbinders hintergreifenden zweiten U-Schenkel, wobei das Verriegelungselement eine Schwenkachse aufweist, die im Übergangsbereich des U-Rückens zum zweiten U-Schenkel angeordnet ist.

Durch die erfindungsgemäße Ausgestaltung des schwenkbaren Verriegelungselements besteht zunächst die Möglichkeit, einen eingesteckten Steckverbinder so zuverlässig in seiner Position zu fixieren, daß ein ungewolltes Lösen des Steckverbinders auch bei rauhen Umgebungsbedingungen und starken Vibrationen zuverlässig verhindert wird. Dadurch, daß das Verriegelungselement näherungsweise U-förmig ausgebildet ist und einen den eingesteckten Steckverbinder abdeckenden U-Rücken sowie einen die Vorderkante des eingesteckten Steckverbinders übergreifenden ersten U-Schenkel aufweist, ist außerdem eine einfache Überprüfung der richtigen, vollständig eingesteckten Position des Steckverbinders im Steckanschluß gewährleistet, da das Verriegelungselement nur dann in die verriegelnde Position schwenkbar ist, wenn der Steckverbinder vollständig in den Steckamehluß eingesteckt ist.

Neben der Funktion des Verriegelns eines eingesteckten Steckverbinders erfüllt das Verriegelungselement gleichzeitig auch noch die Funktion einer Auswurfhilfe beim gewollten Lösen bzw. Herausziehen eines Steckverbinders aus dem Steckanschluß. Hierzu dient der zweite U-Schenkel, der im eingesteckten Zustand eines Steckverbinders eine hintere Kante des Steckverbinders hintergreift. Wird nun das Verriegelungselement aus der verriegelten Position verschwenkt so wird zunächst der Steckverbinder entriegelt, so daß er aus dem Steckanschluß herausgezogen werden kann. Wird das Verriegelungselement jedoch weiter verschwenkt, so drückt das freie Ende des zweiten U-Schenkels gegen eine hintere Kante des Steckverbinders, wodurch dieser aus dem Steckanschluß herausgedrückt bzw. herausgeschoben wird. Das Verriegelungselement hat somit eine Doppelfunktion; zum einen dient es als Verriegelung für einen eingesteckten Steckverbinder, zum anderen kann es jedoch auch als Auswurfhilfe verwendet werden.

Wie eingangs beschrieben worden ist, weist das elektrische oder elektronische Gerät in der Regel an beiden Stirnseiten mindestens einen Steckverbinder, häufig sogar zwei versetzt übereinander angeordnete Steckverbinder, d. h. insgesamt vier Steckverbinder auf, wobei die einzelnen Steckverbinder zum Anschluß von mehreren elektrischen Leitungen ausgebildet sind. In diesem Fall ist dann vorzugsweise vorgesehen, daß an dem Gehäuse auch eine entsprechende Anzahl an Verriegelungselementen schwenkbar angeordnet ist, wobei die Breite der einzelnen Verriegelungselemente der Breite der einzelnen Steckverbinder entspricht, so daß der U-Rücken eines jeden Verriegelungselements den eingesteckten Steckverbinder vollständig abdeckt. Unabhängig davon, daß in der Praxis an einem Gerät in der Regel mehrere Verriegelungselement angeordnet sind, wird nachfolgend stets immer nur ein Verriegelungselement bzw. ein Steckverbinder beschrieben, da meistens alle Verriegelungselemente bzw. alle Steckverbinder eines elektrischen oder elektronischen Geräts gleich ausgebildet sind.

Gemäß einer bevorzugten Ausgestaltung der Erfindung erfolgt die schwenkbare Anordnung eines Verriegelungselements am Gehäuse einfach dadurch, daß an dem Verriegelungselement zwei seitlich vorstehende Drehzapfen ausgebildet sind, die in korrespondierende Ausnehmungen im Gehäuse gelagert sind. Bei den Ausnehmungen für die Drehzapfen kann es sich sowohl um Vertiefungen in den gegenüberliegenden Gehäusewänden als auch um durchgehende Öffnungen handeln. Vorzugsweise sind dabei die Ausnehmungen nach oben offen, so daß ein Verriegelungselement einfach durch Einrasten der Drehzapfen in die entsprechend ausgebildeten Ausnehmungen an dem Gehäuse befestigt werden kann.

Wie zuvor bereits ausgeführt worden ist, sind das Verriegelungselement und der Steckverbinder in ihrer Geometrie aufeinander zumindest teilweise abgestimmt. Die beiden U-Schenkel des Verriegelungselements sind dabei jeweils so ausgebildet, daß sie ihre Funktion möglichst gut und sicher erfüllen. Hierzu ist gemäß einer bevorzugten Ausgestaltung der erste U-Schenkel des Verriegelungselements als Rasthaken ausgebildet, der einen an der Vorderkante des Steckverbinders ausgebildeten Wulst im verriegelten Zustand hintergreift. Außerdem ist zur einfachen Betätigung des Verriegelungselements an diesem ein von außen zugänglicher Griffabschnitt ausgebildet, der vorzugsweise im Übergangsbereich des U-Rückens zum ersten U-Schenkel ausgebildet ist. Der Griffabschnitt kann beispielsweise als vorstehende Kante ausgebildet sein, so daß das Verriegelungselement einfach mit einem Finger aus der verriegelten Position verschwenkt werden kann.

Gemäß einer weiteren bevorzugten Ausgestaltung der Erfindung ist im U-Rücken des Verriegelungselements mindestens eine Öffnung für einen Prüfstecker ausgebildet, so daß auch im verriegelten Zustand des Steckverbinders ein Prüfstecker durch die Öffnung in den Steckverbinder einsteckbar ist. Die bei aus dem Stand der Technik bekannten elektrischen oder elektronischen Geräten häufig vorgesehene Möglichkeit, die einzelnen Anschlüsse eines eingesteckten Steckverbinders mittels eines Prüfsteckers zu kontaktieren, bleibt somit auch bei einem geschlossenen Verriegelungselement erhalten.

Gemäß einer letzten vorteilhaften Ausgestaltung des erfindungsgemäßen elektrischen oder elektronischen Geräts, die hier noch kurz erwähnt werden soll, ist im U-Rücken des Verriegelungselements eine Aufnahme für einen Kennzeichnungsstreifen ausgebildet, wobei die Aufnahme vorzugsweise an der Unterseite des U-Rückens angeordnet ist und zumindest der U-Rücken des Verriegelungselements aus einem transparenten Material besteht. Alternativ dazu kann ein entsprechendes Beschriftungsetikett selbstverständlich auch auf der Oberseite des U-Rückens aufgeklebt oder in eine entsprechende Aufnahme eingeschoben werden. Dadurch wird zusätzlich eine einfache und gut ablesbare Beschriftung der einzelnen Anschlüsse eines Steckverbinders bzw. der einzelnen Steckverbinder ermöglicht.

Wie eingangs ausgeführt, betrifft die vorliegende Erfindung neben einem elektrischen oder elektronischen Gerät auch ein Elektronikgehäuse mit mindestens zwei Steckverbindern zum Anschließen von elektrischen Leitern, wobei in dem Gehäuse mindestens zwei Steckanschlüsse zur Aufnahme der Steckverbinder ausgebildet sind und die Steckanschlüsse jeweils mindestens ein Kontaktelement aufweisen, über die die Steckanschlüsse miteinander oder mit einer in dem Gehäuse angeordneten Elektronik verbunden sind, so daß mit Hilfe der Steckverbinder mindestens zwei elektrische Leitungen miteinander verbindbar oder an die Elektronik anschließbar sind, und wobei im Bereich oberhalb der Steckanschlüsse jeweils ein Verriegelungselement zur Verriegelung eines eingesteckten Steckverbinders schwenkbar angeordnet ist. Bei einem derartigen Elektronikgehäuse ist die der Erfindung zugrundeliegende Aufgabe ebenfalls dadurch gelöst, daß die Verriegelungselemente näherungsweise U-förmig ausgebildet sind, mit einem einen eingesteckten Steckverbinder abdeckenden U-Rücken, einem die Vorderkante eines eingesteckten Steckverbinders übergreifenden, als Rastelement ausgebildeten ersten U-Schenkel und einem eine hintere Kante eines eingesteckten Steckverbinders hintergreifenden U-Schenkel, wobei die Verriegelungselemente eine Schwenkachse aufweisen, die im Übergangsbereich des U-Rückens zu zweiten U-Schenkel angeordnet ist.

Die Anordnung und Ausbildung des Verriegelungselements ist grundsätzlich unabhängig davon, ob bzw. wie die in dem Gehäuse angeordnete Elektronik ausgebildet ist. Grundsätzlich ist es dabei auch möglich, daß das elektronische Gehäuse lediglich zum Verbinden von mindestens zwei an den beiden Steckverbindern angeschlossenen Leitern dient. Das Elektronikgehäuse entspricht dann im wesentlichen von seiner Funktion her einer herkömmlichen Reihenklemme.

Bezüglich der vorteilhaften Ausgestaltung des Verriegelungselements wird zunächst auf die vorherigen Ausführungen zu dem elektrischen bzw. elektronischen Gerät verwiesen. Darüber hinaus besteht das erfindungsgemäße Elektronikgehäuse vorzugsweise aus einem auf eine Tragschiene aufsetzbaren Sockelteil und einem mit dem Sockelteil lösbar verbindbaren Oberteil, wobei zwischen dem Sockelteil und dem Oberteil eine insbesondere rastbare Verriegelung vorgesehen ist. Diese Verriegelung kann dabei beispielsweise aus einem federnden Rastarm am Gehäuseoberteil und einem korrespondierenden Rasthaken am Sockelteil bestehen. Durch die Verriegelung wird ein unbeabsichtigtes Lösen des Oberteils vom Sockelteil verhindert, wobei jedoch gleichzeitig ein gewolltes Öffnen des Gehäuses beispielsweise zum Einsetzen oder Austauschen einer Leiterplatte möglich ist.

Gemäß einer weiteren vorteilhaften Ausgestaltung des erfindungsgemäßen E-lektronikgehäuses ebenso wie des erfindungsgemäßen elektronischen Geräts ist das Sockelteil auf die Tragschiene aufschwenkbar, wobei eine zweite rastbare Verriegelung zur lösbaren Verbindung des Sockelteils mit der Tragschienen vorgesehen ist, die vorzugsweise einen federbelasteten, am Sockelteil verschiebbar gehaltenen Riegel zum einseitigen Verriegeln der Tragschiene aufweist. Dadurch kann das Sockelteil einerseits auf einfache Art und Weise mit der Tragschiene verbunden werden, wobei andererseits ein unbeabsichtigtes Lösen des Sockelteils von der Tragschiene durch die Ausgestaltung des Riegels sicher verhindert wird.

Im einzelnen gibt es nun eine Vielzahl von Möglichkeiten, das erfindungsgemäße Gerät bzw. das erfindungsgemäße Elektronikgehäuse auszugestalten und weiterzubilden. Dazu wird verwiesen sowohl auf die den Patentansprüchen 1 und 10 nachgeordneten Patentansprüche als auch auf die nachfolgende Beschreibung eines bevorzugten Ausfiihrungsbeispiels in Verbindung mit der Zeichnung. In der Zeichnung zeigen
- Fig. 1: ein bevorzugtes Ausführungsbeispiel eines erfindungsgemäßen elektronischen Geräts mit verriegelten Steckverbindern,
- Fig. 2: das elektronische Gerät gemäß Fig. 1, mit einem entriegelten Steckverbinder,
- Fig. 3: das elektronische Gerät gemäß Fig. 1, mit einem eingesteckten Prüfstecker,
- Fig. 4: eine weitere Variante des elektronischen Geräts gemäß Fig. 1,
- Fig. 5: eine vergrößerte Detaildarstellung des elektronischen Geräts, mit einem leicht geöffneten Verriegelungselement, und
- Fig. 6: eine vergrößerte Detaildarstellung gemäß Fig. 5, mit einem voll- ständig geöffneten Verriegelungselement.

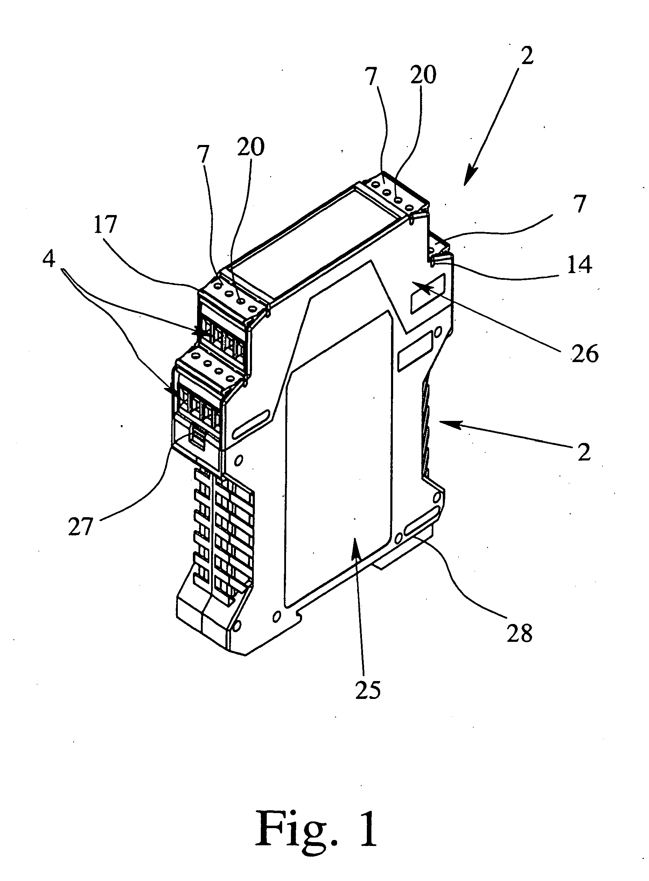

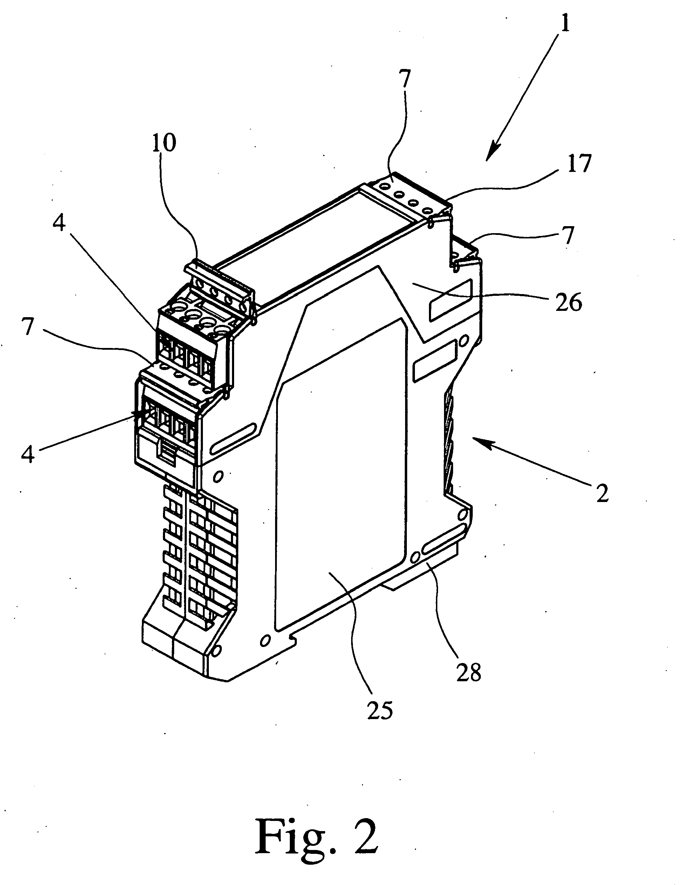

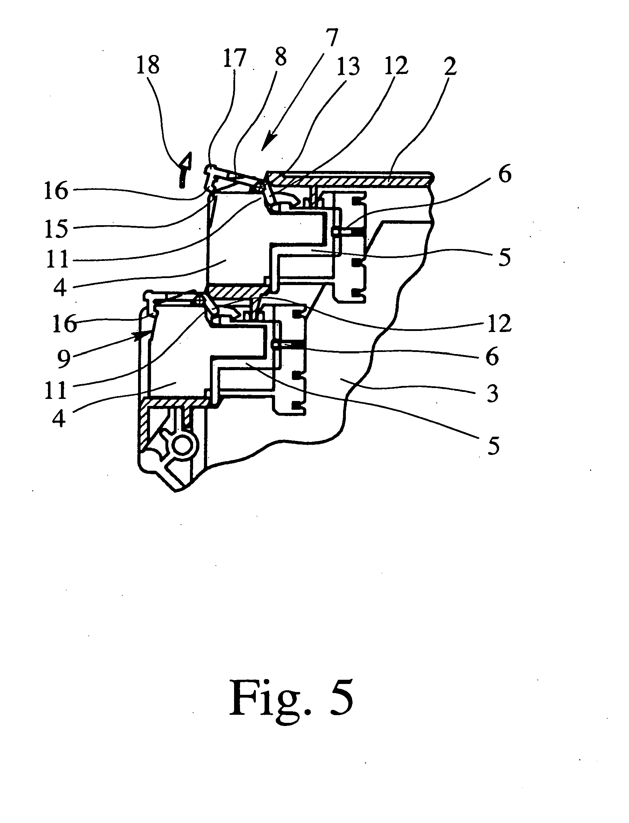

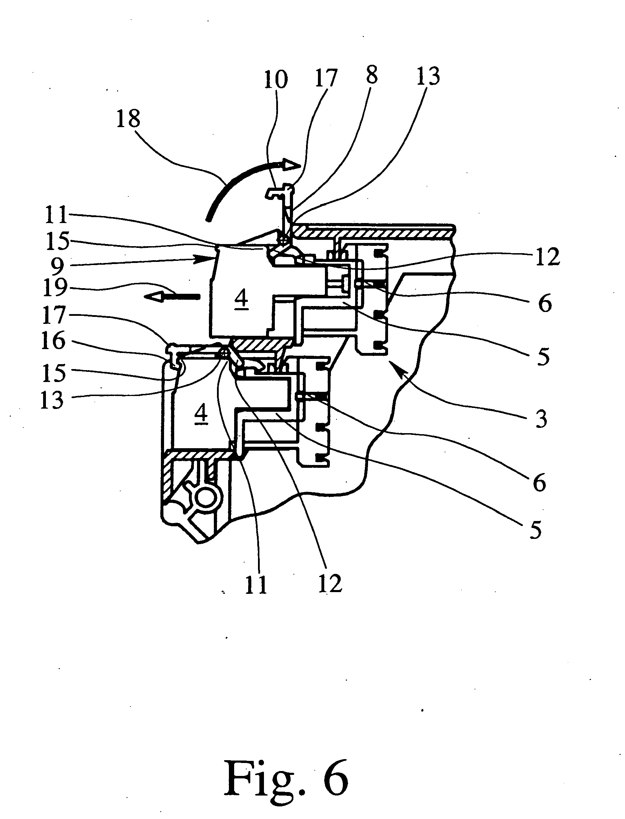

Die Fig. 1 bis 4 zeigen ein bevorzugtes Ausfiihrungsbeispiel eines elektronischen Geräts 1, das auf eine hier nicht dargestellte Tragschiene aufgesetzt werden kann. Das elektronische Gerät 1 weist ein Gehäuse 2, eine in dem Gehäuse 2 angeordnete - nur in den Fig. 5 und 6 angedeutete - Elektronik in Form einer Leiterplatte 3 und insgesamt vier Steckverbinder 4 auf. Die einzelnen Steckverbinder 4 weisen dabei jeweils vier Schraubanschlüsse zum Anschließen von jeweils vier elektrischen Leitungen auf, wobei an jeder Stirnseite des elektronischen Geräts jeweils zwei Steckverbinder 4 treppenartig übereinander angeordnet sind.

In dem Gehäuse 2 sind korrespondierend zu den vier Steckverbindern 4 vier Steckanschlüsse 5 zur Aufnahme der Steckverbinder 4 ausgebildet, wobei die einzelnen Steckanschlüsse 5 jeweils vier Kontaktelemente 6 aufweisen, die fest mit der Leiterplatte 3 verbunden sind. Im eingesteckten Zustand der Steckverbinder 4 kontaktieren die einzelnen Schraubanschlüsse der Steckverbinder 4 jeweils ein Kontaktelement 6, so daß mit Hilfe eines Steckverbinders 4 jeweils vier elektrische Leitungen an die Leiterplatte 3 angeschlossen werden können. Selbstverständliche können die einzelnen Steckanschlüsse 4 anstelle der hier dargestellten Schraubanschlüsse auch Federkraftanschlüsse oder Schneidanschlüsse aufweisen.

Erfindungsgemäß ist nun vorgesehen, daß am Gehäuse 2 im Bereich oberhalb jedes Steckanschlusses 5 jeweils ein Verriegelungselement 7 schwenkbar angeordnet ist, mit dessen Hilfe ein vollständig in einen Steckanschluß 5 eingesteckter Steckverbinder 4 verriegelt werden kann, so wie dies in Fig. 1 bei allen vier Steckverbindern 4 dargestellt ist. Wie insbesondere aus den Fig. 5 und 6 ersichtlich ist, sind die einzelnen Verriegelungselemente 7 näherungsweise U-förmig ausgebildet, so daß sie jeweils einen einen eingesteckten Steckverbinder 4 abdeckenden U-Rücken 8, einen die Vorderkante 9 eines eingesteckten Steckverbinders 4 übergreifenden ersten U-Schenkel 10 und einen eine hintere Kante 11 eines eingesteckten Steckverbinders 4 hintergreifenden zweiten U-Schenkel 12 aufweisen.

Zur schwenkbaren Halterung im Gehäuse 2 weisen die Verriegelungselemente 7 jeweils zwei seitlich vorstehende Drehzapfen 13 auf, die in korrespondierenden Ausnehmungen 14 in den Seitenwänden des Gehäuses 2 gelagert sind. Dadurch, daß die Ausnehmungen 14 nach oben offen sind, können die einzelnen Verriegelungselemente 7 einfach mit ihren Drehzapfen 13 in die Ausnehmungen 14 eingedrückt werden. Die die Drehachse bildenden Drehzapfen 13 befinden sich dabei im Übergangsbereich des U-Rückens 8 zum zweiten U-Schenkel 12.

Wie insbesondere aus Fig. 5 ersichtlich ist, weist der U-Rücken 8 des Verriegelungselements 7 eine solche Länge auf, daß er einen vollständig eingesteckten Steckverbinder 4 vollständig abdeckt. Die Verriegelungselemente 7 können somit auch als verrastbare Klappdeckel bezeichnet werden. Darüber hinaus ist aus den Figuren ersichtlich, daß sowohl der erste U-Schenkel 10 als auch der zweite U-Schenkel 12 kürzer als der U-Rücken 8 ausgebildet ist, wobei der erste U-Schenkel 10, der als Rastelement ausgebildet ist, unter einem Winkel von etwa 90° zum U-Rücken 8 angeordndet ist, während der zweite U-Schenkel 12 zum U-Rücken 8 einen Winkel von ca. 130° aufweist.

Zur sicheren Verriegelung eines vollständig eingesteckten Steckverbinders 4 ist an der oberen Vorderkante 9 des Steckverbinders 4 eine Wulst 15 ausgebildet, die im verriegelten Zustand von einem am freien Ende des ersten U-Schenkels 10 des Verriegelungselements 7 ausgebildeten korrespondierenden Rasthaken 16 übergriffen wird. Zum einfachen Verschwenken des Verriegelungselements 7 weist dieser einen von außen leicht zugänglichen Griffabschnitt 17 auf, so daß das Verriegelungselement 7 einfach mit einem Finger aus der in Fig. 5 beim unteren Verriegelungselement 7 dargestellten vollständig verriegelten Position in eine entriegelte Position verschwenkt werden kann, wie dies bei dem oberen Verriegelungselement 7 in Fig. 5 dargestellt ist. Soll der Steckverbinder 4 aus dem Steckanschluß 5 herausgezogen werden, so kann einfach das Verriegelungselement 7 in Richtung des in den Fig. 5 und 6 dargestellten Pfeiles 18 noch weiter verschwenkt werden, wobei dann der zweite U-Schenkel 12 mit seinem freien Ende gegen die hintere Kante 11 des Steckverbinders 4 drückt, wodurch der Steckverbinder 4 in Richtung des zweiten Pfeiles 19 aus dem Steckanschluß 5 herausgeschoben wird. Das Verriegelungselement 7 dient somit nicht nur zur Verriegelung eines vollständig eingeschobenen Steckverbinders 4 sondern auch als Auswurfhilfe beim gewollten Herausziehen des Steckverbinders 4 aus dem Steckanschluß 5.

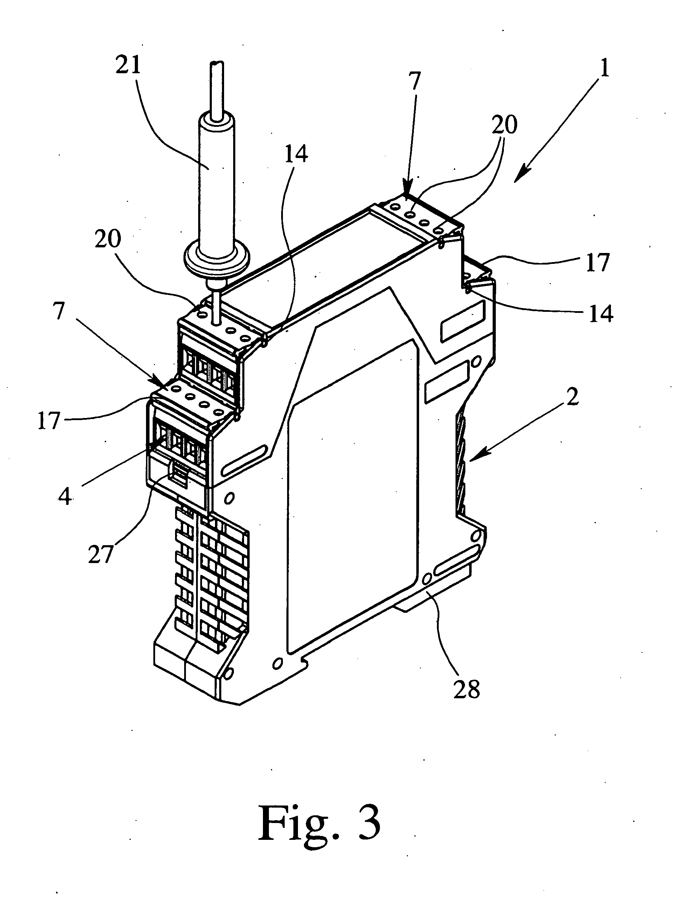

Wie insbesondere aus der Fig. 3 ersichtlich ist, sind im U-Rücken 8 des Verriegelungselements 7 insgesamt vier Öffnungen 20 für einen Prüfstecker 21 ausgebildet, so daß auch im verriegelten Zustand des Steckverbinders 4 mit Hilfe eines Prüfsteckers 21 die einzelnen Schraubanschlüsse des Steckverbinders 4 kontaktiert werden können.

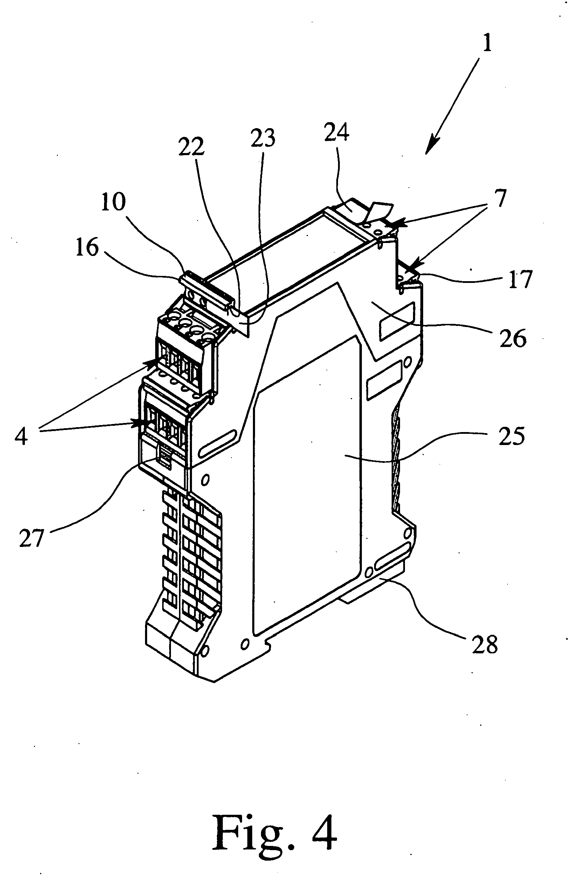

Insbesondere aus der Fig. 4 wird eine weitere Funktion bzw. Anwendungsmöglichkeit des Verriegelungselements 7 ersichtlich. Dabei wird der U-Rücken 8 des Verriegelungselements 7 zur Markierung der einzelnen Steckverbinder 4 bzw. der einzelnen Anschlüsse der Steckverbinder 4 genutzt. Hierzu ist im U-Rücken 8 eine Aufnahme 22 für einen Kennzeichnungsstreifen 23 ausgebildet, wobei bei einer bevorzugten Ausgestaltung das Verriegelungselement 7 insgesamt, zumindest jedoch der U-Rücken 8 aus einem transparenten Material besteht, so daß die Aufnahme 22 für den Kennzeichnungsstreifen 23 an der Unterseite des U-Rückens 8 ausgebildet sein kann. Dies hat den Vorteil, daß der Kennzeichnungsstreifen 23 durch das Verriegelungselement 7 gleichzeitig gegen Beschädigung oder Verschmutzung geschützt wird. Daneben besteht jedoch auch die Möglichkeit, ein Beschriftungsetikett 24 auf der Oberseite des U-Rückens 8 aufzukleben.

Bei dem in den Fig. 1 bis 4 dargestellten elektronischen Gerät 1 ist außerdem noch erkennbar, daß das Gehäuse 2 aus einem auf eine Tragschiene aufsetzbaren Sockelteil 25 und einem Oberteil 26 besteht, wobei das Oberteil 26 über eine rastbare Verriegelung 27 mit dem Sockelteil 25 lösbar verbunden ist. Zur Befestigung des Sockelteils 25 auf einer Tragschiene ist an dem Sockelteil 25 ein federbelasteter Riegel 28 verschiebbar gehalten, der nach dem Aufschwenken des Sockelteils 25 auf die Tragschiene eine Seite der Tragschiene hintergreift.

## Patentansprüche

1. Elektrisches oder elektronisches Gerät, insbesondere zum Aufsetzen auf eine Tragschiene, mit einem Gehäuse (2), mit einer im Gehäuse (2) angeordneten Elektronik, insbesondere einer Leiterplatte (3), und mit mindestens einem Steckverbinder (4), wobei in dem Gehäuse (2) mindestens ein Steckanschluß (5) zur Aufnahme eines Steckverbinders (4) ausgebildet ist und der Steckanschluß (5) mindestens ein Kontaktelement (6) aufweist, das mit der Elektronik verbunden ist, so daß mit Hilfe des Steckverbinders (4) mindestens eine elektrische Leitung an die Elektronik anschließbar ist, und wobei am Gehäuse (2) im Bereich oberhalb mindestens eines Steckanschlusses (5) ein Verriegelungselement (7) zur Verriegelung eines eingesteckten Steckverbinders (4) schwenkbar angeordnet ist,
**dadurch gekennzeichnet,**
**daß** das Verriegelungselement (7) U-förmig ausgebildet ist, mit einem einen eingesteckten Steckverbinder (4) abdeckenden U-Rücken (8), einem die Vorderkante (9) eines eingesteckten Steckverbinders (4) übergreifenden, als Rastelement ausgebildeten ersten U-Schenkel (10) und einem eine hintere Kante (11) eines eingesteckten Steckverbinders (4) hintergreifenden zweiten U-Schenkel (12), und
**daß** das Verriegelungselement (7) eine Schwenkachse aufweist, die im Übergangsbereich des U-Rückens (8) zum zweiten U-Schenkel (12) angeordnet ist.

2. Elektrisches oder elektronisches Gerät nach Anspruch 1, **dadurch gekennzeichnet, daß** das Verriegelungselement (7) zwei seitlich vorstehende Drehzapfen (13) aufweist, die in korrespondierenden Ausnehmungen (14) im Gehäuse (2) gelagert sind.

3. Elektrisches oder elektronisches Gerät nach Anspruch 1 oder 2, **dadurch gekennzeichnet, daß** zumindest der zweite U-Schenkel (12), vorzugsweise sowohl der zweite U-Schenkel (12) als auch der erste U-Schenkel (10) des Verriegelungselements (7) kürzer als der U-Rücken (8) ist bzw. sind.

4. Elektrisches oder elektronisches Gerät nach einem der Ansprüche 1 bis 3, **dadurch gekennzeichnet, daß** der Winkel zwischen dem U-Rücken (8) und dem ersten U-Schenkel (10) des Verriegelungselements (7) etwa 90° und der Winkel zwischen dem U-Rücken (8) und dem zweiten U-Schenkel (12) des Verriegelungselements (7) mehr als 90°, vorzugsweise etwa 115° bis 165° beträgt.

5. Elektrisches oder elektronisches Gerät nach einem der Ansprüche 1 bis 4, **dadurch gekennzeichnet, daß** die Vorderkante (9) des Steckverbinders (4) eine Rastnase oder einen Wulst (15) aufweist, die bzw. der im eingesteckten und verriegelten Zustand des Steckverbinders (4) von einem am freien Ende des ersten U-Schenkels (10) des Verriegelungselements (7) ausgebildeten korrespondierenden Rasthaken (16) übergriffen wird.

6. Elektrisches oder elektronisches Gerät nach einem der Ansprüche 1 bis 5, **dadurch gekennzeichnet, daß** am Verriegelungselement (7) ein von außen zugänglicher Griffabschnitt (17) ausgebildet ist, der vorzugsweise im Übergangsbereich des U-Rückens (8) zum ersten U-Schenkel (10) angeordnet ist.

7. Elektrisches oder elektronisches Gerät nach einem der Ansprüche 1 bis 6, **dadurch gekennzeichnet, daß** im U-Rücken (8) des Verriegelungselements (7) mindestens eine Öffnung (20) für einen Prüfstecker (21) ausgebildet ist, so daß auch im verriegelten Zustand des Steckverbinders (4) ein Prüfstecker (21) durch die Öffnung (20) in den Steckverbinder (4) einsteckbar ist.

8. Elektrisches oder elektronisches Gerät nach einem der Ansprüche 1 bis 7, **dadurch gekennzeichnet, daß** im U-Rücken (8) des Verriegelungselements (7) eine Aufnahme (22) für einen Kennzeichnungsstreifen (23) ausgebildet ist.

9. Elektrisches oder elektronisches Gerät nach Anspruch 8, **dadurch gekennzeichnet, daß** zumindest der U-Rücken (8) des Verriegelungselements (7) aus transparentem Material besteht, und daß die Aufnahme (22) für einen Kennzeichnungsstreifen (23) an der Unterseite des U-Rückens (8) ausgebildet ist.

10. Elektronikgehäuse, insbesondere zum Aufsetzen auf eine Tragschiene (2), mit mindestens zwei Steckverbindern (4) zum Anschließen von elektrischen Leitern, wobei in dem Gehäuse (2) mindestens zwei Steckanschlüsse (5) zur Aufnahme der Steckverbinder (4) ausgebildet sind und die Steckanschlüsse (5) jeweils mindestens ein Kontaktelement (6) aufweisen, über die die Steckanschlüsse (5) miteinander oder mit einer in dem Gehäuse (2) angeordneten Elektronik verbunden sind, so daß mit Hilfe der Steckverbinder (4) mindestens zwei elektrische Leitungen miteinander verbandbar oder an die Elektronik anschließbar sind, und wobei im Bereich oberhalb der Steckanschlüsse (5) jeweils ein Verriegelungselement (7) zur Verriegelung eines eingesteckten Steckverbinders (4) schwenkbar angeordnet ist,
**dadurch gekennzeichnet,**
**daß** die Verriegelungselemente (7) U-formig ausgebildet sind, mit einem einen eingesteckten Steckverbinder (4) abdeckenden U-Rücken (8), einem die Vorderkante (9) eines eingesteckten Steckverbinders (4) übergreifenden, als Rastelement ausgebildeten ersten U-Schenkel (10) und einem eine hintere Kante (11) eines eingesteckten Steckverbinders (4) hintergreifenden zweiten U-Schenkel (12), und
**daß** die Verriegelungselemente (7) eine Schwenkachse aufweisen, die im Übergangsbereich des U-Rückens (8) zum zweiten U-Schenkel (12) angeordnet ist.

11. Elektronikgehäuse nach Anspruch 10, **dadurch gekennzeichnet, daß** die Verriegelungselemente (7) jeweils zwei seitlich vorstehende Drehzapfen (13) aufweisen, die in korrespondierenden Ausnehmungen (14) im Gehäuse (2) gelagert sind.

12. Elektronikgehäuse nach Anspruch 10 oder 11, **dadurch gekennzeichnet, daß** zumindest der zweite U-Schenkel (12), vorzugsweise sowohl der zweite U-Schenkel (12) als auch der erste U-Schenkel (10) des Verriegelungselements (7) kürzer als der U-Rücken (8) ist bzw. sind, und daß der Winkel zwischen dem U-Rücken (8) und dem ersten U-Schenkel (10) etwa 90° und der Winkel zwischen dem U-Rücken (8) und dem zweiten U-Schenkel (12) mehr als 90°, vorzugsweise etwa 115° bis 165° beträgt.

13. Elektronikgehäuse nach einem der Ansprüche 10 bis 12, **dadurch gekennzeichnet, daß** die Vorderkante (9) der Steckverbinder (4) eine Rastnase oder einen Wulst (15) aufweist, die bzw. der im eingesteckten und verriegelten Zustand der Steckverbinder (4) von einem am freien Ende des ersten U-Schenkels (10) des Verriegelungselements (7) ausgebildeten korrespondierenden Rasthaken (16) übergriffen wird, und daß an den Verriegelungselementen (7) ein von außen zugänglicher Griffabschnitt (17) ausgebildet ist, der vorzugsweise im Übergangsbereich des U-Rückens (8) zum ersten U-Schenkel (10) angeordnet ist.

14. Elektronikgehäuse nach einem der Ansprüche 10 bis 13, **dadurch gekennzeichnet, daß** im U-Rücken (8) der Verriegelungselemente (7) mindestens eine Öffnung (20) für einen Prüfstecker (21) ausgebildet ist, so daß auch im verriegelten Zustand der Steckverbinder (4) ein Prüfstecker (21) durch die Öffnung (20) in den Steckverbinder (4) einsteckbar ist.

15. Elektronikgehäuse nach einem der Ansprüche 10 bis 14, **dadurch gekennzeichnet, daß** im U-Rücken (8) der Verriegelungselemente (7) eine Aufnahme (22) für einen Kennzeichnungsstreifen (23) ausgebildet ist, wobei vorzugsweise zumindest der U-Rücken (8) der Verriegelungselemente (7) aus transparentem Material besteht und die Aufnahme (22) für den Kennzeichnungsstreifen (23) an der Unterseite des U-Rückens (8) ausgebildet ist.

16. Elektronikgehäuse nach einem der Ansprüche 10 bis 15, **dadurch gekennzeichnet, daß** das Gehäuse (2) ein auf eine Tragschiene aufsetzbares Sockelteil (25) und ein mit dem Sockelteil (25) lösbar verbindbares Oberteil (26) aufweist, wobei eine insbesondere rastbare Verriegelung (27) zur lösbaren Verbindung des Oberteils (26) mit dem Sockelteil (25) vorgesehen ist.

17. Elektronikgehäuse nach Anspruch 16, **dadurch gekennzeichnet, daß** das Sockelteil (25) auf die Tragschiene aufschwenkbar ist, und daß eine zweite rastbare Verriegelung zur lösbaren Verbindung des Sockelteils (25) mit der Tragschiene vorgesehen ist, die einen federbelasteten, am Sockelteil (25) verschiebbar gehaltenen Riegel (28) zum einseitigen Verriegeln der Tragschiene aufweist.

## Claims

1. Electrical or electronic device, in particular for mounting on a mounting rail, having a housing (2), having an electronics system which is arranged in the housing (2), in particular a printed circuit board (3), and having at least one plug connector (4), with at least one plug connection (5) for receiving a plug connector (4) being formed in the housing (2), and the plug connection (5) having at least one contact element (6) which is connected to the electronics system, and therefore it being possible to connect at least one electrical line to the electronics system with the aid of the plug connector (4), and with a locking element (7) for locking an inserted plug connector (4) being pivotably arranged on the housing (2) in the region above at least one plug connection (5),
**characterized**
**in that** the locking element (7) is of U-shaped design, with a U-spine (8) which covers an inserted plug connector (4), a first U-limb (10) which engages over the front edge (9) of an inserted plug connector (4) and is in the form of a latching element, and a second U-limb (12) which engages behind a rear edge (11) of an inserted plug connector (4), and
**in that** the locking element (7) has a pivot axis which is arranged in the transition region of the U-spine (8) to the second U-limb (12).

2. Electrical or electronic device according to Claim 1, **characterized in that** the locking element (7) has two laterally projecting swivel pins (13) which are mounted in corresponding recesses (14) in the housing (2).

3. Electrical or electronic device according to Claim 1 or 2, **characterized in that** at least the second U-limb (12), preferably both the second U-limb (12) and the first U-limb (10), of the locking element (7) is/are shorter than the U-spine (8).

4. Electrical or electronic device according to one of Claims 1 to 3, **characterized in that** the angle between the U-spine (8) and the first U-limb (10) of the locking element (7) is approximately 90°, and the angle between the U-spine (8) and the second U-limb (12) of the locking element (7) is greater than 90°, preferably approximately 115° to 165°.

5. Electrical or electronic device according to one of Claims 1 to 4, **characterized in that** the front edge (9) of the plug connector (4) has a latching lug or a bead (15), a corresponding latching hook (16) which is formed at the free end of the first U-limb (10) of the locking element (7) engaging over the said latching lug or bead in the inserted and locked state of the plug connector (4).

6. Electrical or electronic device according to one of Claims 1 to 5, **characterized in that** a grip section (17) which is accessible from the outside is formed on the locking element (7) and is preferably arranged in the transition region of the U-spine (8) to the first U-limb (10).

7. Electrical or electronic device according to one of Claims 1 to 6, **characterized in that** at least one opening (20) for a test plug (21) is formed in the U-spine (8) of the locking element (7), and therefore a test plug (21) can be inserted, through the opening (20), into the plug connector (4) in the locked state of the plug connector (4) too.

8. Electrical or electronic device according to one of Claims 1 to 7, **characterized in that** a holder (22) for an identification strip (23) is formed in the U-spine (8) of the locking element (7).

9. Electrical or electronic device according to Claim 8, **characterized in that** at least the U-spine (8) of the locking element (7) is composed of transparent material, and **in that** the holder (22) for an identification strip (23) is formed on the lower side of the U-spine (8).

10. Electronics housing, in particular for mounting on a mounting rail (2), having at least two plug connectors (4) for connecting electrical conductors, with at least two plug connections (5) for holding the plug connectors (4) being formed in the housing (2), and the plug connections (5) each having at least one contact element (6) by means of which the plug connections (5) are connected to one another or to an electronics system which is arranged in the housing (2), and therefore at least two electrical lines can be connected to one another or to the electronics system with the aid of the plug connectors (4), and with in each case one locking element (7) for locking an inserted plug connector (4) being pivotably arranged in the region above the plug connections (5),
**characterized**
**in that** the locking elements (7) are of U-shaped design, with a U-spine (8) which covers an inserted plug connector (4), a first U-limb (10) which engages over the front edge (9) of an inserted plug connector (4) and is in the form of a latching element, and a second U-limb (12) which engages behind a rear edge (11) of an inserted plug connector (4), and
**in that** the locking elements (7) have a pivot axis which is arranged in the transition region of the U-spine (8) to the second U-limb (12).

11. Electronics housing according to Claim 10, **characterized in that** the locking elements (7) each have two laterally projecting swivel pins (13) which are mounted in corresponding recesses (14) in the housing (2).

12. Electronics housing according to Claim 10 or 11, **characterized in that** at least the second U-limb (12), preferably both the second U-limb (12) and the first U-limb (10), of the locking element (7) is/are shorter than the U-spine (8), and **in that** the angle between the U-spine (8) and the first U-limb (10) is approximately 90°, and the angle between the U-spine (8) and the second U-limb (12) is greater than 90°, preferably approximately 115° to 165°.

13. Electronics housing according to one of Claims 10 to 12, **characterized in that** the front edge (9) of the plug connector (4) has a latching lug or a bead (15), a corresponding latching hook (16) which is formed at the free end of the first U-limb (10) of the locking element (7) engaging over the said latching lug or bead in the inserted and locked state of the plug connector (4), and **in that** a grip section (17) which is accessible from the outside is formed on the locking elements (7) and is preferably arranged in the transition region of the U-spine (8) to the first U-limb (10).

14. Electronics housing according to one of Claims 10 to 13, **characterized in that** at least one opening (20) for a test plug (21) is formed in the U-spine (8) of the locking elements (7), and therefore a test plug (21) can be inserted, through the opening (20), into the plug connector (4) in the locked state of the plug connector (4) too.

15. Electronics housing according to one of Claims 10 to 14, **characterized in that** a holder (22) for an identification strip (23) is formed in the U-spine (8) of the locking elements (7), with preferably at least the U-spine (8) of the locking elements (7) being composed of transparent material, and the holder (22) for the identification strip (23) being formed on the lower side of the U-spine (8).

16. Electronics housing according to one of Claims 10 to 15, **characterized in that** the housing (2) has a base part (25) which can be mounted on a mounting rail, and an upper part (26) which can be detachably connected to the base part (25), with an, in particular latchable, lock (27) being provided for detachably connecting the upper part (26) to the base part (25).

17. Electronics housing according to Claim 16, **characterized in that** the base part (25) can be pivoted onto the mounting rail, and **in that** a second latchable lock is provided for detachably connecting the base part (25) to the mounting rail, the said second latchable lock having a spring-loaded bolt (28), which is held on the base part (25) in a slidable manner, for locking the mounting rail

## Revendications

1. Appareil électrique ou électronique, notamment destiné à être placé sur un rail support, comprenant un boîtier (2), avec une électronique disposée dans le boîtier (2), en particulier une carte à circuits imprimés (3), et avec au moins un connecteur enfichable (4), au moins un raccord à fiche (5) étant réalisé dans le boîtier (2) pour recevoir un connecteur enfichable (4), et le raccord à fiche (5) présentant au moins un élément de contact (6) qui est connecté à l'électronique, de sorte qu'au moins une ligne électrique puisse être raccordée à l'électronique au moyen du connecteur enfichable (4), et un élément de verrouillage (7) pour le verrouillage d'un connecteur enfichable (4) enfiché étant disposé de manière pivotante sur le boîtier (2) dans la région au-dessus d'au moins un raccord à fiche (5),
**caractérisé en ce que**
l'élément de verrouillage (7) est réalisé en forme de U, avec une âme de U (8) recouvrant un connecteur enfichable (4) enfiché, une première branche de U (10) réalisée en tant qu'élément encliquetable venant en prise par-dessus l'arête avant (9) d'un connecteur enfichable (4) enfiché, et une deuxième branche de U (12) venant en prise par l'arrière avec une arête arrière (11) d'un connecteur enfichable (4) enfiché, et
**en ce que** l'élément de verrouillage (7) présente un axe de pivotement qui est disposé dans la région de transition de l'âme du U (8) à la deuxième branche du U (12).

2. Appareil électrique ou électronique selon la revendication 1, **caractérisé en ce que** l'élément de verrouillage (7) présente deux tourillons (13) saillant latéralement, qui sont montés dans des évidements correspondants (14) dans le boîtier (2).

3. Appareil électrique ou électronique selon la revendication 1 ou 2, **caractérisé en ce qu'**au moins la deuxième branche du U (12), de préférence la deuxième branche du U (12) et la première branche du U (10) de l'élément de verrouillage (7) est ou sont plus courtes que l'âme du U (8).

4. Appareil électrique ou électronique selon l'une quelconque des revendications 1 à 3, **caractérisé en ce que** l'angle entre l'âme du U (8) et la première branche du U (10) de l'élément de verrouillage (7) vaut environ 90° et l'angle entre l'âme du U (8) et la deuxième branche du U (12) de l'élément de verrouillage (7) vaut plus de 90°, de préférence vaut environ 115° à 165°.

5. Appareil électrique ou électronique selon l'une quelconque des revendications 1 à 4, **caractérisé en ce que** l'arête avant (9) du connecteur enfichable (4) présente un nez d'encliquetage ou un bourrelet (15), qui, dans l'état enfiché et verrouillé du connecteur enfichable (4), est saisi par le dessus par un crochet d'encliquetage (16) correspondant, réalisé à l'extrémité libre de la première branche du U (10) de l'élément de verrouillage (7).

6. Appareil électrique ou électronique selon l'une quelconque des revendications 1 à 5, **caractérisé en ce qu'**une portion de préhension (17) accessible depuis l'extérieur est réalisée sur l'élément de verrouillage (7), laquelle est disposée de préférence dans la région de transition de l'âme du U (8) à la première branche du U (10).

7. Appareil électrique ou électronique selon l'une quelconque des revendications 1 à 6, **caractérisé en ce que** dans l'âme du U (8) de l'élément de verrouillage (7) est réalisée au moins une ouverture (20) pour une fiche de test (21), de sorte qu'une fiche de test (21) puisse être enfichée à travers l'ouverture (20) dans le connecteur enfichable (4) même dans l'état verrouillé du connecteur enfichable (4).

8. Appareil électrique ou électronique selon l'une quelconque des revendications 1 à 7, **caractérisé en ce qu'**un logement (22) est réalisé dans l'âme du U (8) de l'élément de verrouillage (7) pour une bande de repérage (23).

9. Appareil électrique ou électronique selon la revendication 8, **caractérisé en ce qu'**au moins l'âme du U (8) de l'élément de verrouillage (7) se compose de matériau transparent, et **en ce que** le logement (22) pour une bande de repérage (23) est réalisé sur le côté inférieur de l'âme du U (8).

10. Boîtier électronique, en particulier destiné à être placé sur un rail support (2), comprenant au moins deux connecteurs enfichables (4) pour le raccordement de conducteurs électriques, au moins deux raccords à fiche (5) pour recevoir les connecteurs enfichables (4) étant réalisés dans le boîtier (2), et les raccords à fiche (5) présentant à chaque fois au moins un élément de contact (6), par le biais duquel les raccords à fiche (5) sont connectés l'un à l'autre ou à une électronique disposée dans le boîtier (2), de sorte qu'au moins deux conduites électriques puissent être connectées l'une à l'autre à l'aide du connecteur enfichable (4) ou puissent être raccordées à l'électronique, et à chaque fois un élément de verrouillage (7) pour le verrouillage d'un connecteur enfichable (4) enfiché étant disposé de manière pivotante dans la région au-dessus des raccords à fiche (5),
**caractérisé en ce que**
les éléments de verrouillage (7) sont réalisés en forme de U avec une âme de U (8) recouvrant un connecteur enfichable (4) enfiché, une première branche de U (10) réalisée en tant qu'élément encliquetable venant en prise par-dessus l'arête avant (9) d'un connecteur enfichable (4) enfiché, et une deuxième branche de U (12) venant en prise par l'arrière avec une arête arrière (11) d'un connecteur enfichable (4) enfiché, et
**en ce que** les éléments de verrouillage (7) présentent un axe de pivotement qui est disposé dans la région de transition de l'âme du U (8) à la deuxième branche du U (12).

11. Boîtier électronique selon la revendication 10, **caractérisé en ce que** les éléments de verrouillage (7) présentent à chaque fois deux tourillons (13) saillant latéralement, qui sont montés dans des évidements correspondants (14) dans le boîtier (2).

12. Boîtier électronique selon la revendication 10 ou 11, **caractérisé en ce qu'**au moins la deuxième branche du U (12), de préférence la deuxième branche du U (12) et la première branche du U (10) de l'élément de verrouillage (7) est ou sont plus courtes que l'âme du U (8), et **en ce que** l'angle entre l'âme du U (8) et la première branche du U (10) vaut environ 90° et l'angle entre l'âme du U (8) et la deuxième branche du U (12) vaut plus de 90°, de préférence vaut environ 115° à 165°.

13. Boîtier électronique selon l'une quelconque des revendications 10 à 12, **caractérisé en ce que** l'arête avant (9) du connecteur enfichable (4) présente un nez d'encliquetage ou un bourrelet (15) qui, dans l'état enfiché et verrouillé du connecteur enfichable (4), est saisi par le dessus par un crochet d'encliquetage (16) correspondant, réalisé à l'extrémité libre de la première branche du U (10) de l'élément de verrouillage (7), et **en ce qu'**une portion de préhension (17) accessible depuis l'extérieur est réalisée sur l'élément de verrouillage (7), laquelle est disposée de préférence dans la région de transition de l'âme du U (8) à la première branche du U (10).

14. Boîtier électronique selon l'une quelconque des revendications 10 à 13, **caractérisé en ce que** dans l'âme du U (8) de l'élément de verrouillage (7) est réalisée au moins une ouverture (20) pour une fiche de test (21), de sorte qu'une fiche de test (21) puisse être enfichée à travers l'ouverture (20) dans le connecteur enfichable (4) même dans l'état verrouillé du connecteur enfichable (4).

15. Boîtier électronique selon l'une quelconque des revendications 10 à 14, **caractérisé en ce qu'**un logement (22) est réalisé dans l'âme du U (8) de l'élément de verrouillage (7) pour une bande de repérage (23), au moins l'âme du U (8) de l'élément de verrouillage (7) se composant de matériau transparent et le logement (22) pour la bande de repérage (23) étant réalisé sur le côté inférieur de l'âme du U (8).

16. Boîtier électronique selon l'une quelconque des revendications 10 à 15, **caractérisé en ce que** le boîtier (2) présente une partie d'embase (25) pouvant être placée sur un rail support, et une partie supérieure (26) pouvant être connectée de manière amovible à la partie d'embase (25), un verrouillage (27) notamment encliquetable étant prévu pour la connexion amovible de la partie supérieure (26) à la partie d'embase (25).

17. Boîtier électronique selon la revendication 16, **caractérisé en ce que** la partie d'embase (25) peut être pivotée sur le rail support et **en ce qu'**un deuxième verrouillage encliquetable est prévu pour la connexion amovible de la partie d'embase (25) au rail support, qui présente un verrou (28) sollicité par ressort, maintenu de manière déplaçable sur la partie d'embase (25), pour verrouiller d'un côté le rail support
